# EUROPEAN PATENT SPECIFICATION

(11) **EP 0 619 021 B1**
(45) Date of publication and mention of the grant of the patent: **10.04.2002**
(21) Application number: 93901065.8
(22) Date of filing: 22.12.1992
(51) Int. Cl.: G01R 15/24, G01R 19/00, G01J 9/02, G01R 33/032, G01D 5/26

(54) **CURRENT SENSOR**
STROMFÜHLER
DETECTEUR DE COURANT

(30) Priority: 24.12.1991 AU 19391
(43) Date of publication of application: 12.10.1994
(73) Proprietor: THE UNIVERSITY OF SYDNEY, Sydney, New South Wales 2006 (AU)
(72) Inventor: CLARKE, Ian Grainge Dep. of Theoretical Physics, Sydney, NSW 2006 (AU)
(74) Representative: Jones, Colin
(86) International application number: AU9200680
(87) International publication number: WO9313428

(56) References cited:
- EP-A- 0 361 832
- WO-A-89/11110
- GB-A- 2 190 744
- GB-A- 2 251 940
- US-A- 4 370 612
- US-A- 4 542 338
- US-A- 4 545 682
- US-A- 4 634 852
- US-A- 4 773 758
- US-A- 4 848 910
- OPTICS LETTERS, vol.13, no.10, October 1988, WASHINGTON US pages 844 - 846 BASSETT 'DESIGN PRINCIPLE FOR A CIRCULARLY BIREFRINGENT OPTICAL FIBRE'
- REVUE GENERALE DE L'ELECTRICITE, no.4, April 1990, PARIS FR ROYER ET AL. 'CAPTEUR DE COURANT A FIBRE OPTIQUE'
- IEEE TRANSACTIONS ON INSTRUMENTATION AND MEASUREMENT, vol.39, no.1, January 1990, NEW YORK US pages 219 - 224 NICATI ET AL. 'NUMERICAL ANALYSIS OF SECOND ORDER POLARIZATION...'
- PAYNE ET AL.: 'Development of Low- and High-Birefringence Optical Fibers' IEEE JOURNAL OF QUANTUM ELECTRONICS vol. QE-18, no. 4, April 1982, pages 477 - 488
- NICATI ET AL.: "Stabilized Sagnac Optical Fiber Current Sensor Using One Phase and Two Amplitude Modulations", Proc. 8th Optical Fiber Sensors Conference, January 29 -31, 1992, pages 402-405
- LAMING ET AL.: "Compact Optical Fibre Current Monitor with Passive Temperature Stabilisation", Proc. Optical Fiber Sensors Conference, 1988, pages 123-126

## Description

### TECHNICAL FIELD

This invention relates to a sensor, which employs a sensor element composed of spun birefringent optical fibre, for sensing current flow through a conductor.

### BACKGROUND ART

Current sensors which employ optical fibre are used in high voltage systems, for example in electricity generating and distribution systems. Such sensors make use of the Faraday effect to provide a measure of electric current flowing through a conductor and they provide advantages over conventional measuring arrangements that incorporate current transformers. The sensors are light in weight, compact, relatively economical to produce and, most importantly, are electrically insulating.

When light is subjected to the influence of a magnetic field, with the direction of light propagation aligned with the magnetic field, the right-hand circularly polarised mode travels faster than the lefthand circularly polarised mode. This produces a phase shift, the Faraday effect, between the polarisation modes, and the degree of phase shift is proportional to the strength of the magnetic field. Hence, the phase shift is proportional to the current that produces the magnetic field, and the magnitude of current can be inferred from a measurement of the degree of phase shift. However, the Faraday effect is weak and a large number of turns of optical fibre must be wound around a conductor in order to achieve the fibre length required to provide for a measurable phase shift.

Spun birefringent optical fibre might be employed with advantage in the formation of coils having large numbers of turns because, unlike ordinary telecommunications optical fibre, spun birefringent fibre can be wound with a small radius without seriously affecting polarisation properties. This facilitates the manufacture of compact current sensors. However, a problem that arises from the use of spun birefringent optical fibre is that the phase shift between intrinsic polarisation modes of such fibre changes with temperature. A small change in temperature may produce the same phase shift as a large change in current flow through the conductor and, whilst various techniques have been proposed to compensate for the temperature sensitivity of spun birefringent fibre, these involving the introduction of temperature sensitive orthoconjugate reflectors and broadband systems with back reflection.

US-A-4370612 describes the use of an optical fibre wrapped around a conductor. A light beam from a laser is coupled to both ends of the fibre through an optical separation and coupling circuit including a beam separator. In operation, the two light waves flow in the fibre in opposite directions, emerge from both ends and are recombined. The resulting radiation is detected by a photo detector. The resultant current measuring device uses the Faraday effect described above in order to measure current according to the light intensity measured by the photo detector.

GB-A-2190744 discloses an apparatus for sensing magnetic fields using the Faraday effect. An optical fibre is arranged in a coil which has a diminished birefringence produced by spinning during the drawing process. The fibre may be coiled around a conductor to measure the current therein. Measures to compensate for temperature variations and to eliminate stress birefringence are described.

The present invention is directed to a current sensor which is arranged to reduce the effects of temperature sensitivity and which facilitates the fabrication of a compact current sensing device which, depending upon its construction, is suitable for use in various applications.

Accordingly, the present invention provides a current sensor comprising a sensor element which comprises a coil of single-mode birefringent optical fibre which is arranged in use to locate around a current carrying conductor, a light source arranged to emit light which is directed into and through the optical fibre that forms the coil, a beam splitting device optically coupled with the light source and with ends of the optical fibre that forms the coil, and a detector optically coupled to the ends of the optical fibre by way of the beam splitting device, the beam splitting device being arranged to split light from the light source, to launch counter-propagating light beams into the coil by way of the ends of the optical fibre and to combine the counter-propagating light beams that emerge from the ends of the optical fibre, and the detector being arranged to detect a phase shift between polarisation modes of the counter-propagated light beams, the phase shift providing a measure of current flow through the conductor, and the current sensor being characterised in that the optical fibre comprises spun, single-mode birefringent optical fibre; and interference between different elliptical modes of the counter-propagating light beams at the ends of the optical fibre is minimised, thereby to reduce the temperature sensitivity of the sensor.

The sensor is patterned on a Sagnac interferometer, this enabling the employment of spun single mode birefringent optical fibre in formation of the coil. The magnitude of current flowing through a conductor is, in use of the sensor, determined as a measure of the degree of phase shift between the polarisation modes of the counter propagated light beams.

The sensor may be employed solely for detecting the existence of current flow, for example in an earth conductor under fault conditions. However, the sensor in a preferred form may be used for detecting the magnitude of current flow in a conductor and, in such context, the sensor may be employed to provide a measure of magnitude or an indication of the existence of a predetermined magnitude.

The beam splitting device is preferably selected to exhibit temperature stable retardance to avoid the need for introducing a compensating temperature dependent variable. To this end, the beam splitting device should exhibit low retardance relative to the coil fibre.

The optical coupling between the beam splitting device and the ends of the optical fibre is preferably arranged such that the angular relationship between the optical fibre core and the polarisation of the light at any instant in time is substantially the same at both ends of the optical fibre. If this feature is not present in the sensor, then the light source should comprise a source of short wavelength coherent light.

The beam splitting device preferably comprises an optical fibre coupler, typically a 2*2 coupler, but it may alternatively be constituted by a bulk optical beam splitter such as a half-silvered mirror. The beam splitting device most preferably comprises a 3*3 coupler and three detector elements preferably are coupled to the ends of the optical fibre in order to permit determination to be made of the magnitude and direction of current passing through the conductor.

The light source would normally comprise a source of coherent or near coherent light and, thus, would normally comprise a laser or a near-lasing device, such as a super luminescent diode, where the magnitude of current flow is to be measured. However, the light source may comprise a source of non-coherent light in certain applications of the sensor, for example when the mere existence of current is to be sensed.

The detector may be connected either directly or indirectly to the beam splitting device and the detector preferably is in the form of a device which functions to measure the intensity of interfering beams.

The invention will be more fully understood from the following description of a preferred embodiment of a current sensor, the description being provided with reference to the accompanying drawings.

### BRIEF DESCRIPTION OF THE DRAWINGS

In the drawings:
Figure 1 shows a block diagrammatic representation of the current sensor and a portion of a conductor which is surrounded by the current sensor and through which current is passed,
Figures 2 and 3 show schematic representations of alternative embodiments of the sensor, both of which include a 2*2 coupler as a beam splitting device,
Figure 4 shows a graphical analysis of optical signals derived as outputs from the sensor arrangements shown in Figures 2 and 3 together with the waveform of conductor current that is sensed by the sensor,
Figure 5 shows a schematic representation of a further embodiment of the sensor, this including a 3*3 coupler as a beam splitting device,
Figure 6 shows a graphical analysis of optical signals derived as outputs from the sensor arrangements shown in Figure 5 together with the waveform of conductor current that is sensed by the sensor, and
Figure 7 shows the angular relationship desired between respective ends of an optical fibre from which a coil portion of the sensor is wound and the instantaneous polarisation of light entering the core of the fibre at its respective ends.

### MODE FOR CARRYING OUT THE INVENTION

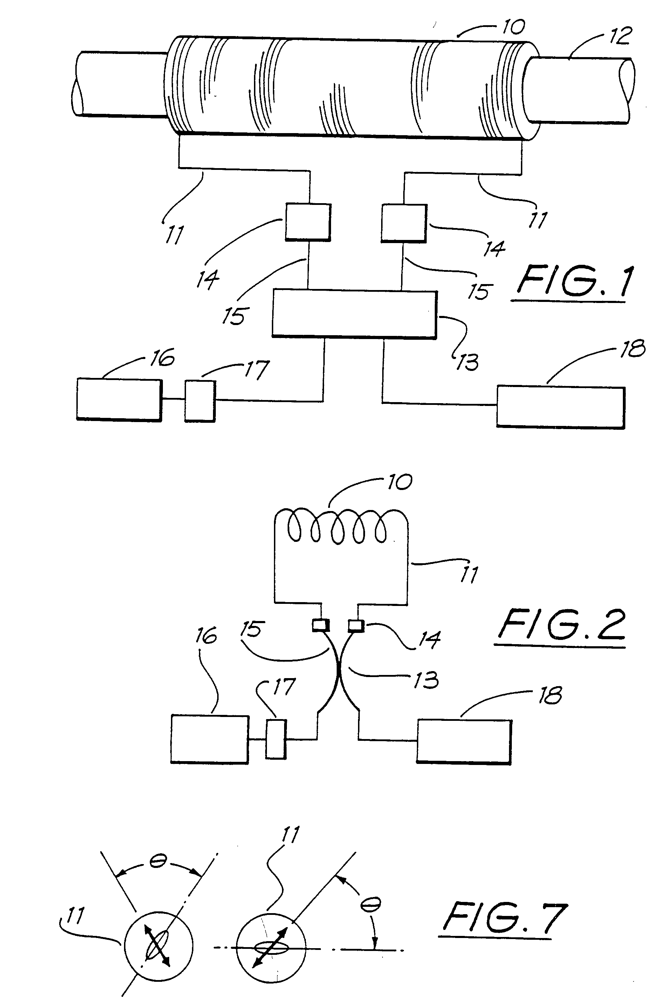

As illustrated in Figures 1 and 2, the current sensor comprises a coil 10 of spun single mode birefringent optical fibre 11. The coil 10 typically has a length in the order of 50cm, a diameter of 10cm and is wound with less than 100m to a maximum of 500m of optical fibre. In use of the sensor the coil 10 is located concentrically about a conductor 12 through which current normally flows.

The coil fibre may comprise form birefringent or stress birefringent fibre (for example, elliptical core fibre or bowtie fibre), and it preferably comprises a bowtie fibre having a core diameter in the order of 4 micrometre and a cladding diameter in the order of 80 micrometre. Also, the fibre has a spun pitch length of 4.8mm and an unspun beat length of 2.4mm.

A 2*2 fused tapered coupler 13 having a low intrinsic retardance (ie., less than about 10°) is spliced to the ends of the coil fibre 11 by connector elements 14 which permit a twisting join (as hereinafter described) to be made between the coupler leads 15 and the ends of the coil fibre.

A light source 16 in the form of a laser diode, which has a lasing wavelength in the order of 670nm, is coupled to both ends of the coil fibre 11 by the coupler 13, and an isolator 17 is provided to prevent reflections back into the light source. Light from the light source 16 is split by the coupler 13 into two counter-propagating beams which enter the respective ends of the coil fibre 11.

A detector 18 is optically coupled to the ends of the coil fibre 11 by way of the coupler 13. The detector comprises a silica photodiode and it functions to measure the intensity of interfering beams. Thus, the detector effectively detects the phase shift between polarisation modes of the counter propagated light beams.

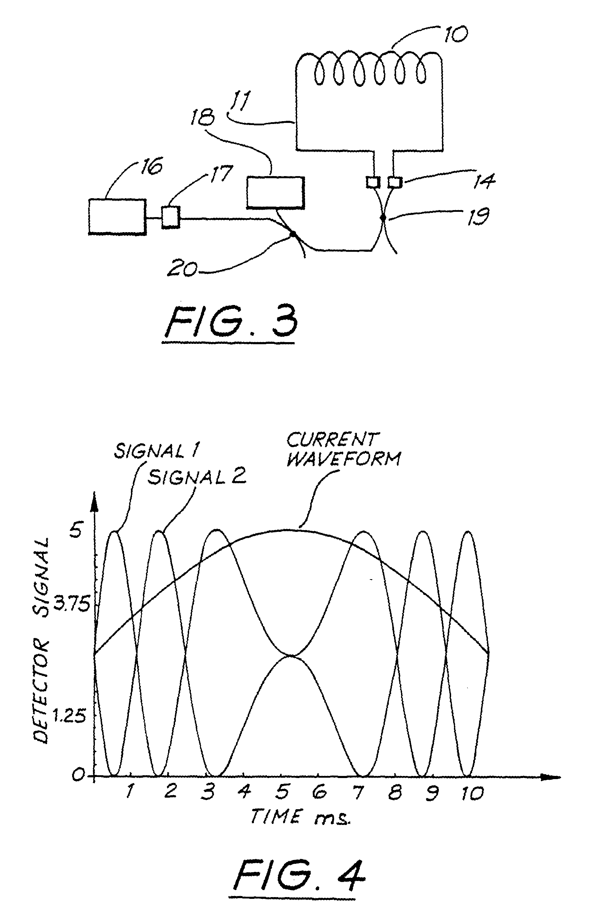

Figure 3 shows an alternative arrangement for the sensor, in which two 2*2 couplers 19 and 20 are employed for optically coupling the light source 16 and the detector 18 to the ends of the coil fibre 11.

When a half silvered mirror or a 2*2 coupler as shown in Figures 2 and 3 is employed as a beam splitting device, two 180° displaced beams are available for detection, one of which may be inferred from the other so that a single detector may be employed. However, as shown in Figure 4, when one optical signal is at a maximum the other is at a minimum and at these turning points the rate of change of light intensity with current drops to zero. Hence, the sensor becomes relatively insensitive to small changes in current. Furthermore, the direction of the current change is unclear because, when at the peak of the sinusoidal optical response, a decrease or increase in the current produces a decrease in the optical output.

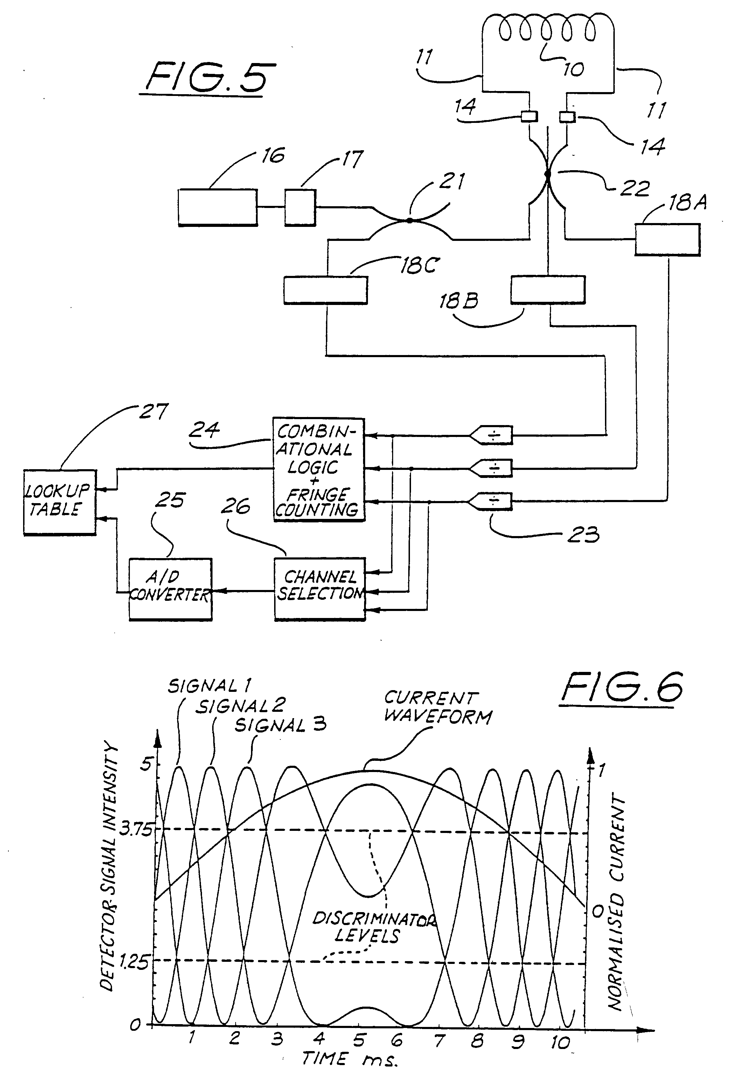

A further, preferred arrangement for the sensor is illustrated in Figure 5 and it shows a sensor arrangement which does at least in part avoid the difficulties that have been described above with reference to Figure 4. In the arrangement shown in Figure 5, a 2*2 coupler 21 and a 3*3 coupler 22 are used for optically coupling light from a single source 16 to the two ends of the coil fibre 11 and for coupling three detector elements 18A, 18B and 18C to the ends of the coil fibre. Thus, the returning light from the coil is split between three fibres and the principal advantage of this arrangement is that it enables the full waveform of the current within the conductor 12 to be reconstructed from the output of the coil 10.

Thus, as indicated in the graphical analysis shown in Figure 6, at any instantaneous value of the current flowing through the conductor, one of the output signals from the coil is in a region where the light intensity changes rapidly with a change in current. This permits derivation of the current direction and magnitude.

As shown in Figure 5, the outputs from the three detector elements 18A, 18B and 18C are applied to analogue dividers 23 which are employed to normalise the signals relative to the laser power of the source 16. Fringe counting is then performed using discriminators and combinational logic 24 which is provided to count fringes and choose the optimum region for fringe interpolation. The discriminators provide a predetermined number of pulses per fringe and the order in which the discriminators trigger is dependent upon the current direction. From this information, the fringe counting produces an eight-bit number corresponding to a coarse measure of the current. Fine resolution within each fringe section is provided by an analogue to digital (A/D) converter 25 which measures the voltage on the fringe selected by asynchronous timing networks 26. The A/D converter has a predetermined number of quantisation levels over the full voltage range of the signal and a majority of these levels fall within discriminator levels between which the interpolation is done. The outputs from the fringe counting network and the A/D converter are applied to a lookup table 27 from which an output having sixteen-bit resolution and linearity is derived.

In each of the above described sensor arrangements, each of the light beams which enters the coil fibre consists of two elliptical polarisation modes. These modes have different phase velocities which are preserved in the presence of small additional birefringence, such as that produced by bending or Faraday rotation, and, in this regard, the modes behave in a similar way to the modes in a linearly birefringent fibre. However, unlike linearly birefringent fibres, these modes do not have a constant polarisation, since, whilst the ellipticity of the modes is constant, the orientation of the major axes of their ellipticity varies periodically along the fibre.

The previously mentioned problem that arises from the temperature induced phase shift between the polarisation modes is obviated in the sensor of the present invention as a consequence of the counter-propagating light beams E⁺ and E⁻. Obviation of the temperature effect may most easily be understood by considering only one of the modes for each direction and, for simplicity, it may be assumed that the fibre has a right-handed spin pitch and that only the counter-propagating right-hand elliptical modes E_{R}⁺ and E_{R}⁻ are excited. Any rise in temperature will cause an identical increase in the phase velocity of both of the right-handed elliptical modes. When these elliptical modes interfere at their output their relative phase will remain unchanged and, hence, the amplitude of the combined wave will also be unchanged. Thus, a change in temperature will not affect the light intensity at the detector.

However, the sensor does remain sensitive to magnetic fields, due to the Faraday effect, since the field affects the counter-propagating beams differently. An increase in the field will cause an increase in the phase velocity of the mode travelling in the direction of the field and a decrease in the velocity of the mode travelling against the field. The modes beat at the output and, thus, the magnitude of the current can be determined as a measure of the phase shift- induced by the magnetic field.

Similarly, if only the left-handed modes E_{L}⁺ and E_{L}⁻ are excited, the output is again unaffected by temperature change but remains sensitive to the magnetic field.

Since both modes in isolation behave in this way, it follows that if the same modes are excited to the same degree in both directions, the effect of changes in temperature will still be eliminated. This occurs when the polarisation of the light which is launched into the two ends of the coil fibre 11 has identical ellipticity and the same orientation relative to the end face of the fibre. This condition is illustrated in Figure 7 of the drawings which shows the same angle θ between the major axis of the core at each end of the fibre 11 and the polarisation angle of entering light. Thus, the optical coupling between the 2*2 coupler and the ends of the coil fibre is arranged such that the angular relationship between the coil fibre core and the polarisation of the light at any instant in time is the same at both ends of the fibre.

This may be achieved by effecting careful alignment of the ends of the fibre before splicing but, in practice, it is easier and more reliable, as above mentioned, to simply twist the complete splice where the coupler leads join the coil fibre so that the end face of the fibre is aligned with the polarisation of the light from the coupler. Since twisting the splice causes an additional small circular birefringence in the coupler leads, the splice must be twisted by an amount approximately 10% greater than that which would normally be required in making a simple comparison of the polarisation state with the orientation of the end face of the fibre.

If polarisation of the light from the coupler is not aligned at the same angle in both directions, then some proportion of the right-handed elliptical mode propagating in one direction will interfere with the left-handed elliptical mode propagating in the other direction, and this interference will be sensitive to temperature change.

## Claims

1. A current sensor comprising:
a sensor element which comprises a coil (10) of single-mode birefringent optical fibre which is arranged in use to locate around a current carrying conductor (12),
a light source (16) arranged to emit light which is directed into and through the optical fibre (11) that forms the coil (10),
a beam splitting device (13) optically coupled with the light source (16) and with the ends of the optical fibre (11) that forms the coil (10) and
a detector (18) optically coupled to the ends of the optical fibre by way of the beam splitting device;
the beam splitting device (13) being arranged to split light from the light source (16) to launch counter-propagating light beams into the coil (10) by way of the ends of the optical fibre (11) and to combine the counter-propagated light beams that emerge from the ends of the optical fibre, and
the detector (18) being arranged to detect a phase shift between polarisation modes of the counter-propagated light beams, the phase shift providing a measure of current flow through the conductor, and
the current sensor being **characterised in that**:
(a) the optical fibre (11) comprises spun, single-mode birefringent optical fibre; and;
(b) interference between different elliptical modes of the counter-propagating light beams at the ends of the optical fibre is minimised, thereby to reduce the temperature sensitivity of the sensor.

2. The current sensor as claimed in claim 1, further **characterised in that** the beam splitting device (13) is selected to exhibit low retardance relative to the optical fibre.

3. The current sensor as claimed in claim 1 or claim 2 further **characterised in that** the optical coupling between the beam splitting device (13) and the ends of the optical fibre (11) is effected in a manner such that the angular relationship (θ) between the optical fibre core and the polarisation of light at any instant in time is substantially the same at both ends of the optical fibre.

4. The current sensor as claimed in any one of claims 1 to 3 further **characterised in that** the light source (16) comprises a source of coherent or near coherent light.

5. The current sensor as claimed in any one of the preceding claims further **characterised in that** the optical fibre (11) comprises a spun stress birefringent fibre.

6. The current sensor as claimed in any one of claims 1 to 4 further **characterised in that** the optical fibre (11) comprises a spun form birefringent fibre.

7. The current sensor as claimed in any one of the preceding claims further **characterised in that** the beam splitting device (13) comprises a 2 x 2 optical coupler.

8. The current sensor as claimed in any one of claims 1 to 6 further **characterised in that** the beam splitting device comprises a 3 x 3 optical coupler (22) and at least two detector devices (18) are coupled to the ends of the optical fibre (11) by the optical coupler (22).

9. The current sensor as claimed in claim 8 further **characterised in that** the light source (16) is coupled to the beam splitting device (22) by way of a 2 x 2 coupler (21), **in that** two of the detector devices (18) are directly coupled to respective ones of two limbs of the 3 x 3 coupler (22) and **in that** a third detector device (18) is directly coupled to one limb of the 2 x 2 coupler (21).

10. The current sensor as claimed in any one of the preceding claims further **characterised in that** the detector (18) is arranged to provide an output which is representative of the intensity of a beam which results from interference in the beam splitting device (13) of the counter-propagated beams.

11. The current sensor as claimed in any one of the preceding claims, further **characterised in that** the manipulation of the elliptical modes of light traversing the sensor element is arranged to minimise interference therebetween.

## Patentansprüche

1. Stromsensor mit
- einem Sensorelement, das eine Spule (10) aus einem doppelbrechenden Einzelglasfaden (11) aufweist, der betriebsmäßig um einen stromführenden Leiter (12) angeordnet ist,
- einer Lichtquelle (16), die derart ausgebildet ist, dass das von ihr ausgehende Licht in den die Spule (10) bildenden Einzelglasfaden (11) gerichtet ist und durch diesen hindurchgeht,
- einer Strahlaufteilungsvorrichtung (13), die mit der Lichtquelle (16) und den Enden der Einzelglasfaser (11) optisch gekoppelt ist und
- einem Detektor (18), der mit den Enden der Einzelglasfaser mittels der Strahlaufteilungsvorrichtung optisch gekoppelt ist,
wobei
- die Strahlaufteilungsvorrichtung (13) derart ausgebildet ist, dass sie das von der Lichtquelle (16) ausgehende Licht in der Weise aufteilt, dass sich entgegengesetzt ausbreitende Lichtstrahlen in die Spule (10) mit Hilfe der Enden der Einzelglasfasern (11) eingegeben werden, und dass sie die sich entgegengesetzt ausbreitenden und aus den Enden der Einzelglasfaser austretenden Lichtstrahlen kombiniert und
- der Detektor (18) derart ausgebildet ist, dass er eine Phasenverschiebung zwischen den Polarisationsmoden der sich entgegengesetzt ausbreitenden Lichtstrahlen erkennt, wobei diese Phasenverschiebung ein Maß des Stromflusses durch den Leiter ist,
**dadurch gekennzeichnet, dass**
(a) die Einzelglasfaser (11) eine gesponnene, doppelbrechende Einzelglasfaser aufweist und
(b) die Interferenz zwischen verschiedenen elliptischen Moden der sich entgegengesetzt ausbreitenden Lichtstrahlen an den Enden der Einzelglasfaser (11) vermindert wird, so dass die Temperaturabhängigkeit des Sensors verringert wird.

2. Stromsensor nach Anspruch 1,
**dadurch gekennzeichnet,**
**dass** die Strahlaufteilungsvorrichtung (13) derart ausgewählt ist, dass sie gegenüber der Einzelglasfaser eine niedrige Verzögerung zeigt.

3. Stromsensor nach Anspruch 1 oder 2,
**dadurch gekennzeichnet,**
**dass** die optische Kopplung zwischen der Strahlaufteilungsvorrichtung (13) und den Enden der Einzelglasfaser (11) in der Weise erfolgt, dass die Winkelbeziehung (θ) zwischen dem Einzelglasfaserkern und der Polarisation des Lichts an beiden Enden der Einzelglasfaser jederzeit im Wesentlichen gleich ist.

4. Stromsensor nach einem der Ansprüche 1 bis 3,
**dadurch gekennzeichnet,**
**dass** die Lichtquelle (16) kohärentes oder fast kohärentes Licht abgibt.

5. Stromsensor nach einem der vorstehenden Ansprüche,
**dadurch gekennzeichnet,**
**dass** die Einzelglasfaser (11) eine gesponnene, biegungsdoppelbrechende Einzelglasfaser ist.

6. Stromsensor nach einem der Ansprüche 1 bis 4,
**dadurch gekennzeichnet,**
**dass** die Einzelglasfaser (11) eine gesponnene, formdoppelbrechende Einzelglasfaser ist.

7. Stromsensor nach einem der vorstehenden Ansprüche,
**dadurch gekennzeichnet,**
**dass** die Strahlaufteilungsvorrichtung (13) einen optischen 2x2-Koppler aufweist.

8. Stromsensor nach einem der Ansprüche 1 bis 6,
**dadurch gekennzeichnet,**
**dass** die Strahlaufteilungsvorrichtung (13) einen optischen 3x3-Koppler (22) aufweist und dass mindestens zwei Detektoreinrichtungen (18) mittels dieses optischen Kopplers (22) mit den Enden der Einzelglasfaser (11) gekoppelt sind.

9. Stromsensor nach Anspruch 8,
**dadurch gekennzeichnet,**
**dass** die Lichtquelle (16) mit der Strahlaufteilungsvorrichtung (22) mittels eines 2x2-Kopplers (21) gekoppelt ist, dass zwei der Detektoreinrichtungen (18) mit zugehörigen zwei Ausgängen der 3x3-Kopplers direkt gekoppelt sind und dass eine drittte Detektoreinrichtung (18) mit einem Ausgang des 2x2-Kopplers (21) direkt gekoppelt ist.

10. Stromsensor nach einem der vorstehenden Ansprüche,
**dadurch gekennzeichnet,**
**dass** der Detektor (18) derart ausgebildet ist, dass er ein Ausgangssignal abgibt, das für die Stärke eines Strahls repräsentativ ist, der sich aus der Interferenz in der Strahlaufteilungsvorrichtung (13) der sich entgegengesetzt ausbreitenden Strahlen ergibt.

11. Stromsensor nach einem der vorstehenden Ansprüche,
**dadurch gekennzeichnet,**
**dass** die Behandlung der elliptischen Moden des das Sensorelement durchlaufenden Lichts derart erfolgt, dass die Interferenz zwischen diesen Moden vermindert wird.

## Revendications

1. Détecteur de courant comprenant :
un élément détecteur constitué d'une bobine (10) de fibre optique biréfringente en mode simple, disposée pour être utilisée autour d'un conducteur transportant du courant (12),
une source de lumière (16) disposée pour émettre de la lumière dirigée vers l'intérieur de la fibre optique (11) formant la bobine (10),
un séparateur de faisceau (13) couplé optiquement à la source de lumière (16) et dont les extrémités de la fibre optique (11) forment la bobine (10) et
un détecteur (18) couplé optiquement aux extrémités de la fibre optique par l'intermédiaire du séparateur de faisceau ;
le séparateur de faisceau (13) est disposé pour séparer la lumière émise de la source de lumière (16) et pour envoyer dans la bobine (10), par les extrémités de la fibre optique (11), des faisceaux lumineux se propageant en sens inverse, et pour combiner les faisceaux lumineux se propageant en sens inverse sortant des extrémités de la fibre optique, et
le détecteur (18), disposé pour détecter un déphasage entre les modes de polarisation des faisceaux lumineux se propageant en sens inverse, le déphasage donnant une mesure du courant traversant le conducteur, et
le détecteur de courant étant **caractérisé en ce que**,
(a) la fibre optique (11) comprend une fibre optique biréfringente simple mode vrillée, et
(b) l'interférence entre différents modes elliptiques des faisceaux lumineux se propageant en sens inverse aux extrémités de la fibre optique est minimisée, réduisant ainsi la sensibilité thermique du détecteur.

2. Détecteur de courant selon la revendication 1, **caractérisé en outre en ce que** le séparateur de faisceau (13) est choisi pour présenter une faible retardance par rapport à la fibre optique.

3. Détecteur de courant selon l'une quelconque des revendications 1 ou 2, **caractérisé en outre en ce que** le couplage optique entre le séparateur de faisceau (13) et les extrémités de la fibre optique (11) est effectué de telle sorte que la relation angulaire (θ) entre le coeur de la fibre optique et la polarisation de la lumière soit à tout instant sensiblement la même aux deux extrémités de la fibre optique.

4. Détecteur de courant selon l'une quelconque des revendications 1 à 3, **caractérisé en outre en ce que** la source lumineuse (16) comprend une source de lumière cohérente ou presque cohérente.

5. Détecteur de courant selon l'une quelconque des revendications précédentes, **caractérisé en outre en ce que** la fibre optique (11) comprend une fibre biréfringente contrainte en torsion.

6. Détecteur de courant selon l'une quelconque des revendications 1 à 4, **caractérisé en outre en ce que** la fibre optique (11) comprend une fibre biréfringente à forme vrillée.

7. Détecteur de courant selon l'une quelconque des revendications précédentes, **caractérisé en outre en ce que** le séparateur de faisceau (13) comprend un coupleur optique 2 x 2.

8. Détecteur de courant selon l'une quelconque des revendications 1 à 6, **caractérisé en outre en ce que** le séparateur de faisceau comprend un coupleur optique 3 x 3 (22) et **en ce qu'**au moins deux éléments détecteurs (18) sont couplés aux extrémités de la fibre optique (11) par le coupleur optique (22).

9. Détecteur de courant selon la revendication 8, **caractérisé en outre en ce que** la source lumineuse (16) est couplée au séparateur de faisceau (22) par l'intermédiaire d'un coupleur 2 x 2 (21), **en ce que**, deux des éléments détecteurs (18) sont directement couplés aux deux membres respectifs du coupleur 3 x 3 (22) et **en ce qu'**un troisième élément détecteur (18) est directement couplé à un membre du détecteur 2 x 2 (21).

10. Détecteur de courant selon l'une quelconque des revendications précédentes, **caractérisé en outre en ce que** le détecteur (18) est disposé pour fournir un signal de sortie représentatif de l'intensité d'un faisceau résultant de l'interférence dans le séparateur (13) entre les faisceaux se propageant en sens inverse.

11. Détecteur de courant selon l'une quelconque des revendications précédentes, **caractérisé en outre en ce que** la modification des modes elliptiques de la lumière traversant l'élément détecteur est effectuée afin de minimiser les interférences.
